# EUROPEAN PATENT SPECIFICATION

(11) **EP 1 981 141 B1**
(45) Date of publication and mention of the grant of the patent: **26.11.2014**
(21) Application number: 08159973.0
(22) Date of filing: 16.12.1999
(51) Int. Cl.: H02H 3/06, H02H 7/26

(54) **Method in connection with protective relay and protective relay**
Verfahren in Verbindung mit einem Schutzrelais und Schutzrelais
Procédé en connexion avec un relais de protection et relais de protection

(30) Priority: 17.12.1998 FI 982741
(43) Date of publication of application: 15.10.2008
(62) Divisional of application: 99660191.0
(73) Proprietor: ABB Oy, 00380 Helsinki (FI)
(72) Inventor: Kuisti, Harri, 00200, Helsinki (FI)
(74) Representative: Kolster Oy Ab

(56) References cited:
- US-A- 4 710 841
- US-A- 5 543 995

## Description

### FIELD OF THE INVENTION

The present invention relates to a method and protective relay according to the preambles of independent claims 1 and 8.

### BACKGROUND OF THE INVENTION

To minimise feed disconnections caused by faults in the electrical power network the known solutions often include a so-called auto-reclosing relaying which recloses a switch a while after it has opened. Since most of the faults in an open-wire network are electric arc faults, which disappear when the faulty line is disconnected for a short time, the distribution of electricity can often be continued by means of auto-reclosing. Sometimes the fault does not disappear when the switch is open. Then the switch is closed against the fault and new relay operation and the opening of the switch are required immediately.

Traditional solutions include pre-set lengths for the times the switch is open, i.e. the 'dead times' of auto-reclosing sequences. For example, the switch can at first be held open for a short time, e.g. 150 ms, and then the auto-reclosing can be made. It the fault is eliminated by this so-called high speed automatic reclosing, the switch can be held closed and the power distribution can be continued as usual. If the line still has the fault, the switch is reopened for a longer time, e.g. for 1 minute. Then the switch is closed again. If the fault is eliminated by this so-called delayed auto-reclosing, the switch can be held closed and the power distribution can be continued as usual. Otherwise the relay trips the line definitively out of the network and it is set out to find the fault. There are different variations of the simple auto-reclosing sequence described above; however, they all have a common feature that the lengths of the dead times are set in advance.

If the line comprises a capacitor battery, the opening of the line switch may cause resonance to the line. The resonance frequency depends on the values of the total capacitance and total inductance of the line. Resonance may cause overvoltages to the line and damage the components on the line. It is important that such a resonance is recognised so that the network topology can be selected such that resonances do not occur when the lines and line sections are disconnected. Traditionally there have been no methods to achieve this purpose, since voltages have not usually been measured from the disconnected lines in the distribution network.

### BRIEF DESCRIPTION OF THE INVENTION

The object of the present invention is to provide a method by which the above drawback can be avoided and to enable the implementation of auto-reclosings and feed changes in a more reliable way. This object is achieved by the method of the invention, which method is characterized by what is stated in independent claim 1.

The invention is based on the idea of forming parameters describing the state of a disconnected line, line section or busbar from voltages measured from the disconnected line, line section or busbar in three phases and determining a resonant overvoltage of the line, line section or busbar on the basis of the parameters.

By means of the invention it is possible to recognise the resonance and its frequency behind the opened switch, whereby the network topology can be changed in order to avoid resonance in the future. According to the invention, the inventive idea of determining the state of an electrical power network can be used in connection with all connections in the network, whereby the tendency of the infallible network to resonant overvoltages can be detected.

The solution of the invention is implemented by means of the measurements of signals which have either a fundamental frequency or a lower frequency, whereby the used technology is reliable and preferable.

The invention further relates to a protective relay according to independent claim 8, by which protective relay the advantages provided by the method of independent claim 1 are achieved by means of a simple structure.

### BRIEF DESCRIPTION OF THE DRAWINGS

The invention is now described in greater detail in connection with the preferred embodiments with reference to the attached drawings, in which
Figure 1 shows phase voltages of an electrical power network measured from a line during a two-phase short circuit:
Figure 2 shows main voltages of an electrical power network measured from a line during a two-phase short circuit:
Figure 3 shows the zero voltage of an electrical power network measured from a line during a phase-to-earth fault;
Figure 4 shows phase voltages of an electrical power network measured from a line during a phase-to-earth fault; and
Figure 5 shows main voltages of an electrical power network measured from a line during a three-phase short circuit.

### DETAILED DESCRIPTION OF THE INVENTION

When a voltage feed is switched off from a line or line section, the line or line section does not immediately become dead, since motor loads loading the line function as generators inducing alternating voltages to the line.

In accordance with the method of the invention, a fault is detected on a line or line section of an electrical power network. The fault can be e.g. a short circuit or an earth fault which affects the normal operation of the electrical power network. As the fault is detected on the line or line section, the faulty section is disconnected from the other network, i.e. the faulty section is separated. The disconnection takes place in a protective relay or in a switching device in connection with it, which may be a mechanical switching element or a semiconductor switch, for example.

According to the method of the invention, after the fault detection and the disconnection of the faulty network section, voltage is measured from the disconnected line or line section. Voltage is measured by means of a voltage determination element adapted to the protective relay or to its connection. According to the invention voltage is thus measured from a disconnected line or line section. From the measured voltages, parameters describing the state of the disconnected section are formed. The parameters are formed in a processing element of the protective relay, which processing element is in connection with the voltage determination element.

After the parameters have been formed, the processing element concludes, on the basis of the parameters, the disappearance or possibility of disappearance of the fault of the disconnected line or line section. The parameters are formed according to the preferred embodiment of the invention in such a manner that the amplitude magnitude of a fundamental-frequency component of one or more phase or main voltages of the disconnected line or line section is determined. The forming of parameters may further comprise the step of comparing predetermined amplitude magnitudes with each other.

After the disappearance or possibility of disappearance of the fault is determined on the basis of the parameters, the line or line section disconnected according to the preferred embodiment of the invention is reconnected to the network after a predetermined time has passed.

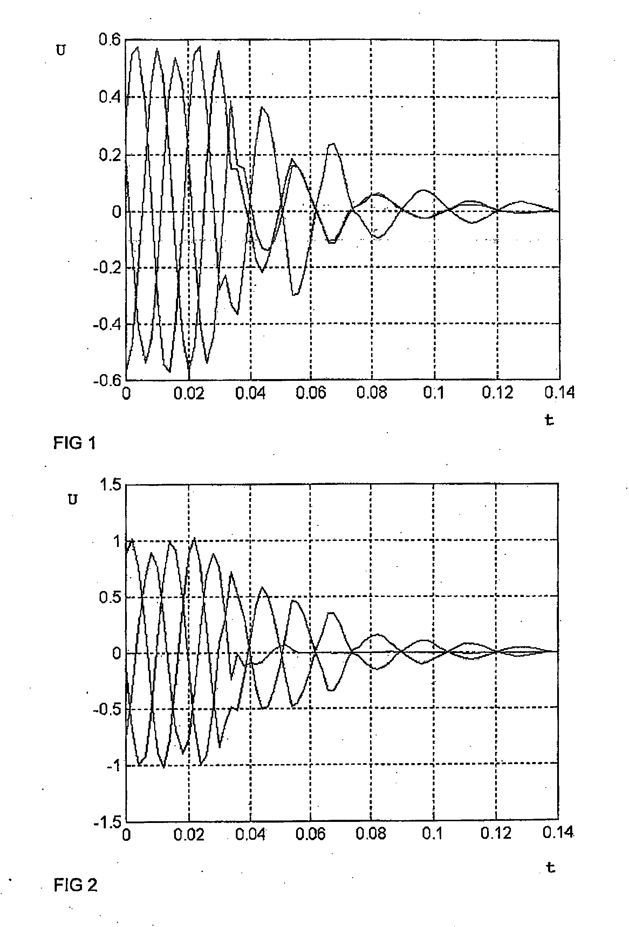

Figures 1 and 2 show examples of the voltage behaviour of a line or line section disconnected from the network in a situation in which the fault does not disappear while the switch is open. Figure 1 shows phase voltages measured from the line after the line has been disconnected as a result of a two-phase short circuit. The switch opens approximately at the instant 0.03 s, but the short circuit between the two phases does not disappear immediately. The voltages of the faulty phases follow each other, which indicates that the fault is still affecting.

Figure 2 shows main voltages measured from the line after the line has been disconnected as a result of a two-phase short circuit. The switch opens approximately at the instant 0.03 s, but the short circuit between the two phases does not disappear immediately. Since one main voltage remains low, this means that two phases are still in a short circuit. The main voltages of the figure relate to the phase voltages of Figure 1.

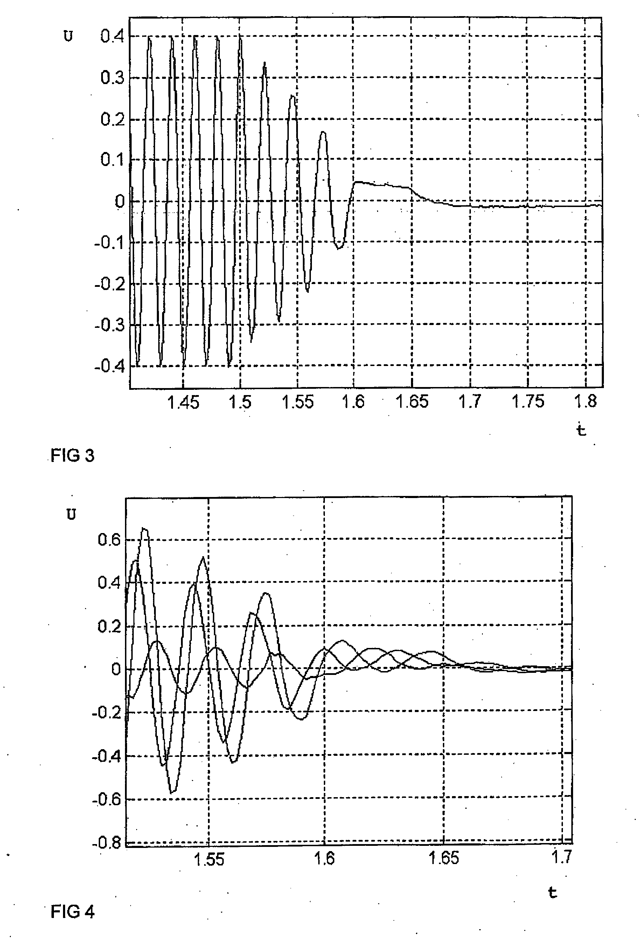

If the fault disappears while the switch is open, voltages change their nature. Examples of this are shown in Figures 3 and 4, Zero voltage, which means the sum of phase voltages as such or multiplied by a constant, becomes a low-frequency voltage as the fault disappears. The low frequency is determined by the natural frequency of the resonant circuit formed by the inductances and capacitances of the line. The phase voltages relating to the corresponding situation are shown in Figure 4. At first, the voltage of the faulty phase is clearly the lowest, but as the fault disappears, all phase voltages are approximately of the same magnitude.

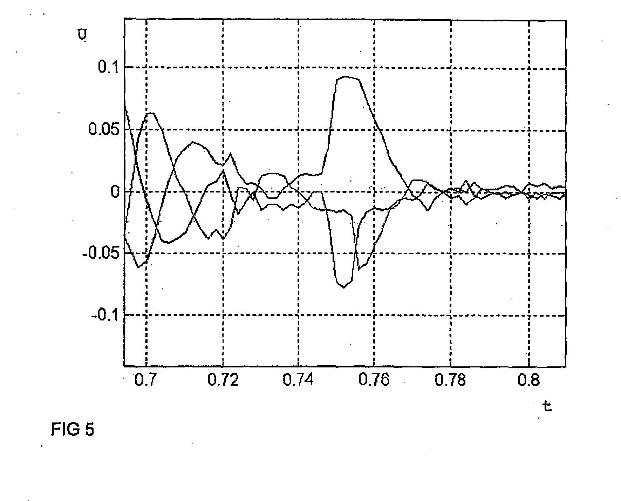

Figure 5 relates to the disappearance of a three-phase short circuit after the opening of the switch. All main voltages increase rapidly, when the short circuit disappears.

The damping of voltages in Figures 1 to 5 is caused by the fact that cage induction motors functioning as loads on the line cannot maintain the voltage, because the magnetization current derived from the natural capacitances of the line is not sufficient for the motors. The decrease in the frequency, for its part, is caused by the retardation of the motors functioning as loads, as the power feed exits.

If the fault does not disappear when the switch opens, the nature of voltages behind the open switch depends on the fault type. In a two-phase short circuit the voltage between faulty phases is very low compared with other main voltages. This kind of a situation is illustrated in Figure 2. If the two-phase fault disappears, the main voltage between the faulty phases increases to the same level as that of other main voltages.

The existence of a phase-to-earth fault also after the switch has opened can be concluded from the fact that the zero voltage remains high and the voltage of the faulty phase remains low compared with other phase voltages. When the earth fault disappears, the amplitude and frequency of the zero voltage decrease and the voltage of the faulty phase becomes as high as other phase voltages. Both the existence and the disappearance of the fault later on can be seen from Figures 3 and 4, in which the switch opens at the instant 1.5 s and the earth fault remains until the instant 1.6 s. Figure 4 shows phase voltages measured from the line after the line has been disconnected as a result of a phase-to-earth fault.

Figure 5 shows main voltages measured from the line after the line has been disconnected as a result of a three-phase short circuit. The switch opens approximately at the instant 0.68 s, but the short circuit disappears only at the instant 0.75 s, which can be seen as a sudden increase in the main voltages.

A parameter according to the method of the invention is, for example, a relation of the amplitude of a fundamental frequency component of the main voltage between the phases in a two-phase short circuit to the amplitude of a fundamental-frequency component of the highest main or phase voltage. The disappearance of the two-phase short circuit can be concluded from the fact that the voltages of the faulty phases are no longer the same. In the solution of the invention, the disappearance of the two-phase fault can be detected without any switching measures and by utilizing the measurements of the voltages induced by a motor load.

Another possible parameter is formed by the amplitudes of all fundamental frequency components of the phase or main voltages or the amplitude and frequency of the component having the greatest amplitude in the frequency spectrum of all phase or main voltages. The disappearance of the three-phase short circuit is manifested in the sudden rise in all phase or main voltages.

A parameter may also be the biggest instantaneous value of all phase and main voltages, the frequency of the component having the greatest amplitude in the frequency spectrum of the zero voltage or the time between two successive sign reversal points of the zero voltage.

The disappearance of a phase-to-earth fault can be detected by the method of the invention on the basis of the following criteria. The earth fault has disappeared, if the frequency of the component having the greatest amplitude in the frequency spectrum of the zero voltage goes below a predetermined limit, or if the time between two successive sign reversal points of the zero voltage exceeds a predetermined limit. The criteria for detecting the disappearance of a phase-to-earth fault can also be applied to detect the absence or disappearance of a ground contact in connection with two-phase and three-phase faults. By means of these conclusions, the safety of people can be improved considerably.

When voltages on the line or line section have decreased below a certain limit, there exists favourable conditions for a fault to disappear. It is already known that motor loads on the line generate alternating voltages to the line, and that they retard the disappearance of the fault during the dead time of the auto-reclosing. According to the method of the invention, these voltages are measured from the line, whereby it can be immediately detected when the favourable conditions for the disappearance of the fault are created in the prevailing connection situation of loads. The load situation varies, and when the traditional solution is employed, the dead time of the auto-reclosing has to be selected according to the connection situation having the greatest motor load and the slowest voltage damping, which leads to a gratuitously long dead time for other connection situations.

From the parameters formed according to the invention, the resonant overvoltage of a line or line section is determined and the personnel of the electrical power network is informed of either the appearance of the resonant overvoltage or its magnitude and/or frequency. Resonant overvoltages can be identified in such a manner that the highest instantaneous value of one or all main or phase voltages or the amplitude of the wave component having the greatest amplitude exceeds a predetermined limit. A possibility of the appearance of resonant overvoltages in connection with switching measures of the network is already known. According to the preferred embodiment of the invention, the appearance of resonant overvoltages on a disconnected line or busbar of a distribution network is detected by directly measuring the voltages of said line sections whenever the switch or other switching device opens. This determination of the resonant overvoltage can also be applied when it does not deal with a fault situation nor an auto-reclosing.

When it is detected that the fault has disappeared or that there are favourable conditions for the disappearance of the fault due to the decreased voltages, the same or a different feed can be switched on according to a preferred embodiment of the invention at the substation or disconnector satellite substation of the distribution network. If the fault disappeared immediately when the switch opened, the fault was on the feed side, when it is better to change the feed. And if the fault disappeared only some time after the switch opened, the fault was not on the feed side, and the same feed can safely be switched on again. If it cannot be detected that the fault has disappeared, the switch is not connected at all for safety reasons or one of the supplies can be switched on after a predetermined time has passed since the conditions for the disappearance of the fault were created.

On the basis of voltage measurements and the parameters based on them, a faulty line section can be disconnected from the network by means of disconnectors controlled by local automatics. In this case, the voltage measurements and the conclusions based on them are made separately for the line sections located on different sides of the disconnector. The disconnector is opened, when the parameters calculated from the voltages indicate that the fault was produced in the electrical power network. Then the disconnector is rapidly reclosed, if the voltages on both sides of the disconnector indicate that there is not a fault on said line sections. The disconnector can be closed already during the dead time of the high speed automatic reclosing, whereby another auto-reclosing and phased closings of the disconnectors need not be performed at all, and there will be no other relay operation nor an interruption in the feed resulting thereof. As a result there is a considerably shorter interruption in the distribution than in the traditional method based on local logic.

The method of the invention can basically be also employed in auto-reclosings that are made in connection with earth faults of an underground system, if it is detected that by employing the method of the invention the earth fault has disappeared. The method also enables a rapid return of the feed at the substation, switching substation or disconnector satellite substation also when the fault is located behind the opened switch, but it disappears when the switch opens. The information on the disappearance of the fault is not available in the traditional solutions, and the rapid feed return would require risk-taking.

By using feed change automatics utilizing the known over-current locking the solution of the invention may create an additional criterion for detecting the disappearance of the fault. The solution of the invention can thus be employed to support the known method for improving reliability.

The method of the invention requires the measurement of voltage from the line behind the switch connected to the protective relay, and not from the busbar system, as usual. Then an additional voltage measuring device is needed to implement the auto-reclosing relaying according to the invention, the voltage measuring device measuring the voltage behind the switch. On the other hand, more and more voltage detectors or sensors behind the switch are also used in other purposes, whereby the solution of the invention does not cause extra costs. In many new switchgear the voltage measurement from each line behind the switch is already a standard solution. Further, it is to be noted that the solution of the invention applied to feed change relaying of substations and switching stations operates specifically by means of the measurements of busbar voltages, whereby no additional voltage measuring devices are required.

According to an embodiment of the invention, the protective relay do not perform an auto-reclosing at all, unless it can be detected that the fault has disappeared during the time when the voltages behind the switch still exceed a predetermined level, whereby the fault is interpreted to be permanent.

The method of the invention can be applied for example in such a manner that the auto-reclosing is not made after the predetermined time has passed since the fault has disappeared, but it is waited until the voltages on both sides of the switch are in the same phase. This variation requires that at least one main voltage or phase voltage is measured before the switch, if the length of the dead time of the auto-reclosing is longer than a few seconds. If the dead time of the auto-reclosing is short, the voltages on the network side of the switch can be supposed to remain approximately in the same phases until the auto-recfosing is made. The relay may thus store the phase angles of the voltages measured before the switch has opened in memory and make the auto-recfosing at the moment when the phase angles of the voltages measured behind the open switch after the disappearance of the fault are the same as the phase angles stored in the memory. If the network frequency differs from the nominal value, then the voltage phasors measured by means of the known recursive Fourier filter rotate at the angular frequency of ω = 2 * π * (f - fₙ). Thus, the relay measures the frequency before the switch opens and changes the phase angles stored in the memory according to the above mentioned rotating frequency and calculates the estimates for the phase angles of the voltages on the network side of the open switch.

In many cases, the disappearance of an earth fault can be detected by measuring one phase voltage, since the low-frequency zero voltage generated when the fault disappears is high in comparison with the fundamental-frequency phase voltages generated by the motors functioning as loads. The low-frequency zero voltage is summed to the fundamental-frequency voltage causing the time between the successive zero points to often become longer. The disappearance of the earth fault can thus also be detected by measuring the time between the successive zero points of one phase voltage. If it exceeds the determined limit, the earth fault is interpreted to have disappeared.

The most preferable alternative in case of short circuits is to permit an auto-reclosing, when it is detected that the fault has disappeared, or the voltage has decreased so low that it is likely that the electric arc fault disappears. The electric arc may be lit between the faulty phases so long that the voltages are high enough to be measured. It is not thus always possible to detect the disappearance of the short circuit fault during the time that the voltages behind the open switch decrease. If the auto-reclosing were not made, unless it can be detected that the fault has disappeared, the auto-reclosing would not be made at all in many such cases in which the fault only disappears after the voltage has decreased considerably.

In case of earth faults, the most preferable alternative depends on what kind of impedances between phase conductors and the earth there are on the line behind the open switch and how harmful an unsuccessful auto-reclosing against the earth fault is regarded to be. If the impedances between the phase conductors on the line and the earth enable a sufficiently great earth fault current on a disconnected line, the electric arc of the earth fault may be lit so long that the voltages behind the switch are sufficiently high to be measured. It is thus not always possible to detect the disappearance of the earth fault during the time the voltages behind the open switch decrease.

If the impedances between the phases of the line and the earth do not allow a considerable earth fault current on the disconnected line, the electric arc of the earth fault quenches and it is most likely that the fault disappears rapidly after the switch opens. The earth fault current usually decreases after the switch has opened so much that the electric arc quenches immediately. In such a case, it is preferable not to make auto-reclosings, unless it can be detected that the fault has disappeared. If the ground contact is maintained with a very low current, then it most likely deals with a permanent fault.

If an unsuccessful auto-reclosing on the earth fault is considered to be a big danger for humans and animals, it is most preferable, regardless of the nature of the earthing system, not to make auto-reclosings, unless it can be detected that the earth fault has disappeared after the switch has opened.

To minimise network interferences, it is most preferable to make the auto-reclosing at the moment the voltages on both sides of the switch are at the same phase.

It is obvious to a person skilled in the art that as the technology develops, the basic idea of the invention can be implemented in a variety of ways. The invention and its embodiments do not thus restrict to the above examples, but they may vary in the scope of the claims.

## Claims

1. A method in connection with a protective relay, the protective relay being connected to an electrical power network, the method comprising the steps of:
disconnecting a line, line section or busbar, **characterized by** further comprising the steps of:
measuring voltages from the disconnected line, line section or busbar in three phases,
forming parameters describing the state of the disconnected line, line section or busbar from the measured voltages,
determining a resonant overvoltage of the line, line section or busbar on the basis of the parameters, and
informing the personnel of the electrical power network of the resonant overvoltage or its magnitude and/or frequency.

2. A method as claimed in claim 1, **characterized by** the forming of the parameters describing the state of the disconnected line, line section or busbar comprising the step of determining the amplitude magnitude of a fundamental-frequency component of one or more phase or main voltages of the disconnected line, line section or busbar.

3. A method as claimed in claim 2, **characterized by** further comprising the step of comparing the amplitude magnitudes with each other.

4. A method as claimed in claim 1, **characterized by** the forming of the parameters describing the state of the disconnected line, line section or busbar comprising the step of determining the amplitude and frequency of the component having the greatest amplitude in the frequency spectrum of all phase or main voltages.

5. A method as claimed in claim 1, **characterized by** the forming of the parameters describing the state of the disconnected line, line section or busbar comprising the step of determining the highest instantaneous value of all phase or main voltages of the disconnected line, line section or busbar.

6. A method as claimed in claim 1, **characterized by** the forming of the parameters describing the state of the disconnected line, line section or busbar comprising the step of determining the frequency of the component having the greatest amplitude in the frequency spectrum of the zero voltage of the disconnected line, line section or busbar.

7. A method as claimed in claim 1, **characterized by** the forming of the parameters describing the state of the disconnected line, line section or busbar comprising the step of determining the time between two successive sign reversal points of the zero voltage of the disconnected line, line section or busbar.

8. A protective relay comprising a switching element to disconnect and connect a faulty line, line section or busbar in three phases, **characterized in that** the protective relay comprises:
a voltage determination element adapted to determine the magnitudes of voltages from a disconnected line, line section or busbar in three phases in an electrical power network in connection with the protective relay, and
a processing element adapted to form parameters describing the state of the disconnected line, line section or busbar from the measured voltages, to determine a resonant overvoltage of the line, line section or busbar on the basis of the parameters, and to inform personnel of the electrical power network of the resonant overvoltage or its magnitude and/or frequency.

## Patentansprüche

1. Verfahren in Verbindung mit einem Schutzrelais, wobei das Schutzrelais mit einem Elektrizitätsversorgungsnetz verbunden ist und das Verfahren folgende Schritte umfasst:
Trennen einer Leitung, eines Leitungsabschnitts oder einer Sammelschiene, **dadurch gekennzeichnet, dass** es des Weiteren folgende Schritte umfasst:
Messen der Spannungen an der getrennten Leitung, dem Leitungsabschnitt oder der Sammelschiene in drei Phasen,
Bilden von Parametern, die den Status der getrennten Leitung, des Leitungsabschnitts oder der Sammelschiene beschreiben, anhand der gemessenen Spannungen,
Bestimmen einer Resonanzüberspannung der Leitung, des Leitungsabschnitts oder der Sammelschiene auf der Basis der Parameter, und
Informieren des Personals des Elektrizitätsversorgungsnetzes über die Resonanzüberspannung oder deren Größe und/oder Frequenz.

2. Verfahren nach Anspruch 1, **dadurch gekennzeichnet, dass** das Bilden der Parameter, die den Status der getrennten Leitung, des Leitungsabschnitts oder der Sammelschiene beschreiben, folgenden Schritt umfasst: Bestimmen der Amplitudengröße einer Grundfrequenzkomponente einer oder mehrerer Phasen oder Hauptspannungen der getrennten Leitung, des Leitungsabschnitts oder der Sammelschiene.

3. Verfahren nach Anspruch 2, **dadurch gekennzeichnet, dass** es des Weiteren folgenden Schritt umfasst: Vergleichen der Amplitudengrößen miteinander.

4. Verfahren nach Anspruch 1, **dadurch gekennzeichnet, dass** das Bilden der Parameter, die den Status der getrennten Leitung, des Leitungsabschnitts oder der Sammelschiene beschreiben, folgenden Schritt umfasst: Bestimmen der Amplitude und Frequenz der Komponente, welche die größte Amplitude in dem Frequenzspektrum aller Phasen oder Hauptspannungen aufweist.

5. Verfahren nach Anspruch 1, **dadurch gekennzeichnet, dass** das Bilden der Parameter, die den Status der getrennten Leitung, des Leitungsabschnitts oder der Sammelschiene beschreiben, folgenden Schritt umfasst: Bestimmen des höchsten Momentanwerts aller Phasen oder Hauptspannungen der getrennten Leitung, des Leitungsabschnitts oder der Sammelschiene.

6. Verfahren nach Anspruch 1, **dadurch gekennzeichnet, dass** das Bilden der Parameter, die den Status der getrennten Leitung, des Leitungsabschnitts oder der Sammelschiene beschreiben, folgenden Schritt umfasst: Bestimmen der Frequenz der Komponente, welche die größte Amplitude in dem Frequenzspektrum der Nullspannung der getrennten Leitung, des Leitungsabschnitts oder der Sammelschiene aufweist.

7. Verfahren nach Anspruch 1, **dadurch gekennzeichnet, dass** das Bilden der Parameter, die den Status der getrennten Leitung, des Leitungsabschnitts oder der Sammelschiene beschreiben, folgenden Schritt umfasst: Bestimmen der Zeit zwischen zwei aufeinander folgenden Vorzeichenumkehrpunkten der Nullspannung der getrennten Leitung, des Leitungsabschnitts oder der Sammelschiene.

8. Schutzrelais, umfassend ein Schaltelement zum Trennen und Verbinden einer fehlerhaften Leitung, eines Leitungsabschnitts oder einer Sammelschiene in drei Phasen, **dadurch gekennzeichnet, dass** das Schutzrelais umfasst:
ein Spannungsbestimmungselement, das dazu eingerichtet ist, die Größen der Spannungen einer getrennten Leitung, eines Leitungsabschnitts oder einer Sammelschiene in drei Phasen in einem Elektrizitätsversorgungsnetz in Verbindung mit dem Schutzrelais zu bestimmen, und
ein Verarbeitungselement, das dazu eingerichtet ist, Parameter, die den Status der getrennten Leitung, des Leitungsabschnitts oder der Sammelschiene beschreiben, anhand der gemessenen Spannungen zu bilden, eine Resonanzüberspannung der Leitung, des Leitungsabschnitts oder der Sammelschiene auf der Basis der Parameter zu bestimmen, und das Personal des Elektrizitätsversorgungsnetzes über die Resonanzüberspannung oder deren Größe und/oder Frequenz zu informieren.

## Revendications

1. Procédé en relation avec un relais de protection, le relais de protection étant connecté à un réseau d'alimentation électrique, le procédé comprenant les étapes :
de déconnexion d'une ligne, d'une section de ligne ou d'une barre de bus, **caractérisé en ce qu'**il comprend en outre les étapes :
de mesure des tensions de la ligne, de la section de ligne ou de la barre de bus déconnectée en trois phases,
de formation de paramètres décrivant l'état de la ligne, de la section de ligne ou de la barre de bus déconnectée à partir des tensions mesurées,
de détermination d'une surtension de résonance de la ligne, de la section de ligne ou de la barre de bus sur la base des paramètres, et
d'information du personnel du réseau d'alimentation électrique de la surtension de résonance ou de son amplitude et/ou de sa fréquence.

2. Procédé selon la revendication 1, **caractérisé en ce que** la formation des paramètres décrivant l'état de la ligne, de la section de ligne ou de la barre de bus déconnectée comprend l'étape de détermination de la valeur d'amplitude d'une composante de fréquence fondamentale d'une ou de plusieurs tensions de phase ou principales de la ligne, de la section de ligne ou de la barre de bus déconnectée.

3. Procédé selon la revendication 2, **caractérisé en ce qu'**il comprend en outre l'étape de comparaison des valeurs d'amplitude les unes avec les autres.

4. Procédé selon la revendication 1, **caractérisé en ce que** la formation des paramètres décrivant l'état de la ligne, de la section de ligne ou de la barre de bus déconnectée comprend l'étape de détermination de l'amplitude et de la fréquence de la composante ayant l'amplitude la plus grande amplitude dans le spectre de fréquence de toutes les tensions de phase ou principales.

5. Procédé selon la revendication 1, **caractérisé en ce que** la formation des paramètres décrivant l'état de la ligne, de la section de ligne ou de la barre de bus déconnectée comprend l'étape de détermination de la valeur instantanée la plus élevée de toutes les tensions de phase ou principales de la ligne, de la section de ligne ou de la barre de bus déconnectée.

6. Procédé selon la revendication 1, **caractérisé en ce que** la formation des paramètres décrivant l'état de la ligne, de la section de ligne ou de la barre de bus déconnectée comprend l'étape de détermination de la fréquence de la composante ayant l'amplitude la plus grande dans le spectre de fréquence de la tension nulle de la ligne, de la section de ligne ou de la barre de bus déconnectée.

7. Procédé selon la revendication 1, **caractérisé en ce que** la formation des paramètres décrivant l'état de la ligne, de la section de ligne ou de la barre de bus déconnectée comprend l'étape de détermination du temps entre deux points d'inversion de signe successifs de la tension nulle de la ligne, de la section de ligne ou de la barre de bus déconnectée.

8. Relais de protection comprenant un élément de commutation pour déconnecter et connecter une ligne, une section de ligne ou une barre de bus défaillant en trois phases, **caractérisé en ce que** le relais de protection comprend :
un élément de détermination de tension conçu pour déterminer les amplitudes des tensions d'une ligne, d'une section de ligne ou d'un barre de bus déconnectée en trois phases dans un réseau d'alimentation électrique en relation avec le relais de protection, et
un élément de traitement conçu pour former des paramètres décrivant l'état de la ligne, de la section de ligne ou de la barre de bus déconnectée à partir des tensions mesurées, pour déterminer une surtension de résonance de la ligne, de la section de ligne ou de la barre de bus sur la base des paramètres, et pour informer le personnel du réseau d'alimentation électrique de la surtension de résonance ou de son amplitude et/ou de sa fréquence.
